Europäisches Patentamt

European Patent Office

Office européen des brevets

(11) Publication number : **0 447 260 A2**

# (12) EUROPEAN PATENT APPLICATION

(21) Application number : **91302261.2**

(22) Date of filing : **15.03.91**

(51) Int. Cl.⁵ : **H01L 39/24**

(30) Priority : **15.03.90 US 493640**

(43) Date of publication of application :
**18.09.91 Bulletin 91/38**

(84) Designated Contracting States :
**AT BE CH DE DK ES FR GB GR IT LI LU NL SE**

(71) Applicant : **UNIVERSITY OF ARKANSAS**
**P.O. Box 3017**
**Little Rock, Arkansas 72203 (US)**

(72) Inventor : **Shams, Qamar Ahmad, Dr.**
**551 Lowells Avenue, Apt. 4**
**Cincinnati, Ohio 45220 (US)**
Inventor : **Hermann, Allen M., Dr.**
**2704 Lookout View Drive**
**Golden, Colorado 80481 (US)**
Inventor : **Sheng, Zhengzhi, Dr.**
**Carlson Terrace, University of Arkansas**
**Fayetteville, Arkansas 72701 (US)**

(74) Representative : **Sheard, Andrew Gregory et al**
**Kilburn & Strode 30, John Street**
**London WC1N 2DD (GB)**

(54) T12Ca2Ba2Cu3Ox superconducting films and process for their preparation.

㊄ A method for making Tl-Ca-Ba-Cu-O super-conductive materials as films are disclosed. After placing a $Ca_2Ba_2Cu_3O_7$ powder on to a suitable substrate, such as platinum or copper, the substrate and powder are rolled between two rollers until a desired thickness is achieved. The film can then be removed from the substrate. Thallium oxide is then evaporated on the film to make a superconductive film. The $Tl_2O_3$ can be evaporated in a furnace or vacuum.

EP 0 447 260 A2

# Tl$_2$Ca$_2$Ba$_2$Cu$_3$Ox SUPERCONDUCTING FILMS AND PROCESS FOR THEIR PREPARATION

The present invention relates to superconductors, such as high temperature superconductors. More specifically, the present invention provides for the fabrication of (for example, high temperature) superconducting films, tapes and wires (such as thick films, tapes and wires).

A variety of superconducting systems are already known in the art. Although superconducting materials have a great many potential applications, due to their physical nature and structure it is often difficult to fabricate superconductive materials into useful shapes. Such useful shapes include films, tapes and wires. The ability to fabricate superconducting materials into these useful shapes may provide many advantages, for example low cost processing and manufacturing and may assist to guide the manufacture of new and higher temperature superconducting films. Furthermore, in connection with the Tl-Ca-Ba-Cu-O superconducting system, the ability to fabricate such shapes may minimise the potential problems due to the toxicity and volatility of Tl$_2$O$_3$ superconducting materials.

U.S. Patent Application Serial No. 155,247, filed on 12th February 1988 in the names of Hermann and Sheng, discloses Tl-Ca-Ba-Cu-O superconducting materials and processes for making them.

EP-A-0356231 discloses processes for making Tl-Ca-Ba-Cu-O superconductors. This document also discloses a Tl$_2$O$_3$ evaporation process in which Ca-Ba-Cu-O precursors may be formed into Tl-Ca-Ba-Cu-O.

Thus according to a first aspect of the present invention there is provided a process for the preparation of a superconducting film, the process comprising evaporating Tl$_2$O$_3$, either in flowing oxygen at atmospheric pressure, or in a vacuum, on to a Ba-Ca-Cu-O precursor film.

Both the precursor film and the superconducting film are preferably thick. In this specification, the term "thick" when used in relation to a film (or a layer) means that it has a thickness of at least 10 microns. Preferably the thickness of either the precursor and/or superconducting film is from 40 to 70 microns.

The precursor film is suitably prepared from compounds of barium, calcium and copper. At least one compound will usually contain oxygen. These compounds are suitably oxides and/or carbonates. Preferably calcium oxide (CaO) and copper oxide (CuO) are mixed with either barium oxide (BaO) or barium carbonate (BaCO$_3$). Thus it is preferred that a mixture of calcium oxide, barium carbonate and copper oxide, or a mixture of calcium oxide, barium oxide and copper oxide are used. The preferred compounds of calcium barium and copper are suitably ground and mixed to provide a calcium-barium-copper-oxide mixture.

The precursor film suitably has the general formula:

$$Ca_xBa_yCu_uO_v$$

wherein:

x is greater than or equal to 0.5 and less than or equal to 6;

y is greater than or equal to 0.25 and less than or equal to 2;

u is greater than or equal to 0.5 and less than or equal to 7.5; and

v is greater than or equal to x+y+u and less than or equal to x+y+u+2

Preferably the precursor has the folmula Ca$_2$Ba$_2$Cu$_3$O$_x$ (e.g. x = 2).

The calcium-barium-copper-oxide mixture is suitably first heated at a temperature of from 900 to 950°C, such as about 925°C. This is suitably for at least 24 hours.

The film may then be prepared from the barium-calcium-copper-oxide mixture. This is suitably achieved by rolling. Thus, the mixture is suitably rolled to make the (e.g. thick) film which may be achieved by using a plurality (such as two) rollers. Although not essential, it is preferred that the mixture is rolled on a substrate to form the film. Preferred substrates are metallic, for example they may comprise copper and/or platinum.

In a preferred embodiment the precursor film is removed from the substrate before thallium oxide is evaporated on to the film.

The evaporation of the thallium oxide may be conducted either under atmospheric pressure (for example in a furnace) or in a vacuum. If conducted at atmospheric pressure, this is suitably in the presence of flowing oxygen. The temperature is suitably at from 850° to 950°C, such as about 900°C. This may be up to about 5 minutes, such as at about 3 minutes. The film is suitably held above the thallium oxide which is evaporated.

However, as discussed previously it will be appreciated that the evaporation of the thallium oxide may take place in a vacuum. Suitably pressure will be as low as about 5x10$^{-6}$ Torr. The thallium oxide will be suitably contacted with the precursor film for up to about 1 minute, such as about 30 seconds. Once vacuum evaporation has taken place, in a preferred embodiment the thallium oxide then is evaporated under atmospheric pressure, such as in a furnace, to contact the film as previously described. Thus both vacuum evaporation and (subsequent) atmospheric pressure evaporation of the thallium oxide may be used to prepare the superconducting films of the present invention.

The superconducting films of the present invention suitably have the general formula:
$$Tl_zCa_2Ba_2Cu_3O_{7+1.5z}$$
wherein z is greater than or equal to 0.5 and less than or equal to 2.

The superconducting film may then be used to make a superconducting wire or tape.

After the thallium oxide has been evaporated to contact the precursor film the resultant material may then be annealed. This is suitably in flowing oxygen. Preferably this is at a temperature of from 850° to 950°C, such as about 900°C.

Thus a preferred process of the present invention comprises:

rolling a Ca-Ba-Cu-O powder between rollers to form a film;

evaporating $Tl_2O_3$ on to the resulting Ca-Ba-Cu-O film; and

annealing the resultant $Tl_2O_3$-coated film.

In a particularly preferred process, a (e.g. high temperature) superconducting film (which is a thick film) may be prepared by:

grinding a mixture of CaO and CuO and either BaO or $BaCO_3$;

heating the ground mixture to obtain a $Ca_xBa_yCu_uO_v$ mixture;

forming the $Ca_xBa_yCu_uO_v$ mixture into a thick film;

evaporating $Tl_2O_3$ on to the thick film; and

annealing the $Ca_xBa_yCu_uO_v$ thick film coated with $Tl_2O_3$.

The $Ca_xBa_yCu_uO_v$ mixture is suitably heated at approximately 925°C for about 2 4 hours. This mixture may be rolled to make the thick film whereupon the $Tl_2O_3$ is evaporated on to the film in a vacuum.

The present invention thus provides a process for the manufacture of Tl-Ca-Ba-Cu-O superconducting film. The process includes evaporating thallium oxide in a furnace or vacuum evaporator on to a rolled Ca-Ba-Cu-O film. The process may thus result in the creation of a superconducting Tl-Ca-Ba-Cu-O film. Preferably the process results in the creation of a superconducting Tl-Ca-Ba-Cu-O thick film. The Tl-Ca-Ba-Cu-O superconducting films may be produced by a process comprising:

(1) rolling a Ca-Ba-Cu-O film on to a platinum or some other suitable substrate; and

(2) evaporating the thallium oxide on to the Ca-Ba-Cu-O film.

The process suitably includes annealing the resultant thallium oxide evaporated film.

The Ca-Ba-Cu-O film may be made by rolling a suitable (e.g. $Ca_2Ba_2Cu_3O_x$) mixture usually a powder, down between two rollers, on to a substrate, at room temperature. The film may then be taken off the substrate.

Thallium oxide can then be evaporated on to the film (with or without the substrate) by thermal evaporation in a vacuum. However, the $Tl_2O_3$ may be evapo-

rated on to the film by using a vapour process.

The process of the present invention may thus create a Tl-Ca-Ba-C-O superconducting film or tape. The film or tape can then be fabricated into wire. The superconductors made by the present invention suitably have the approximate stoichiometry:
$$TlCa_xBa_yCu_uO_v$$
wherein:

x is greater than or equal to 0.5 and less than or equal to 6 (or $0.5 \leq x \leq 5$);

y is greater than or equal to 0.25 and less than or equal to 2;

u is greater than or equal to 0.5 and less than or equal to 7.5; and

v is greater than or equal to x+y+u and less than or equal to x+y+u+2.

One advantage of the present invention is that it may provide a relatively easy method for forming superconducting films or tapes. It may also provide a method for creating superconducting thick films or tapes for use in wire making.

A further advantage of the present invention is that it may provide a Tl-Ca-Ba-Cu-O film that may exhibit extremely low resistivity in the normal state.

Thus the present invention may provide an improved method for creating materials having superconductive properties.

A still further advantage of the present invention is that it may provide a more commercially viable superconductive material.

The present invention thus provides a process for the preparation of Tl-Ca-Ba-Cu-O films and wires, as well as films and wires made therefrom. A preferred process for preparing Tl-Ca-Ba-Cu-O superconducting films according to the present comprises:

(1) preparing a Ba-Ca-Cu-O precursor film by a rolling method;

(2) vapour processing the rolled Ba-Ca-Cu-O precursor film with $Tl_2O_3$; and

(3) annealing the thallium oxide evaporated film.

The vapour processing is suitably performed in a furnace at a temperature of approximately 900°C, such as in flowing oxygen, at atmospheric pressure.

Another preferred process for preparing Tl-Ca-Ba-Cu-O superconducting films comprises:

(1) preparing a Ba-Ca-Cu-O precursor film by a rolling method;

(2) evaporating $Tl_2O_3$ on to the rolled precursor Ba-Ca-Cu-O film in a vacuum evaporator; and

(3) annealing the thallium oxide evaporated film.

The annealing is suitably performed in a furnace at a temperature of about 900°C with flowing oxygen.

The process of the present invention may thus provide high quality Tl-Ca-Ba-Cu-O superconducting film. Moreover, the process may provide a relatively simple and low cost procedure for processing and manufacturing Tl-Ca-Ba-Cu-O superconducting films and tapes that can be processed into wire.

The resultant films of the present invention may demonstrate extremely low resistivity, for example in the order of $2 \times 10^{-4}$ ohm-cm at room temperature. Some of the films, with their platinum substrate, may have an even lower resistivity, such as in the order of $4.8 \times 10^{-5}$ ohm-cm at room temperature.

In the process of the present invention, a calcium-barium-copper-oxide mixture is suitably prepared. This mixture is preferably prepared by grinding and mixing CuO and CaO with either $BaCO_3$ or $BaO_2$.

Preferably after the grinding and mixing step the resultant calcium-barium-copper-oxide powder is then heated. For example, the resultant powder may be heated in an atmospheric environment at approximately 900°C for approximately 24 hours.

The calcium-barium-copper-oxide powder may then be placed on to a substrate, for example a platinum or copper substrate and then passed between rollers. The calcium-barium-copper-oxide, now in the form of a film may then either be vapour processed with thallium oxide in a furnace with flowing oxygen, or thallium oxide may be evaporated on to the Ca-Ba-Cu-O film in a vacuum evaporator.

Preferably the film has a thickness of from 40 microns to 70 microns.

A second aspect of the present invention relates to a process for the preparation of a superconducting film, the process comprising rolling a mixture of compounds of barium, calcium and copper, at least one of which is an oxide, into a precursor film, and contacting this precursor film with $Tl_2O_3$ vapour.

A third aspect of the present invention relates to a process for the preparation of a superconducting film, the process comprising forming a Ba-Ca-Cu-O precursor film on a substrate, removing the precursor film from the substrate and contacting the precursor film with $Tl_2O_3$ vapour.

A fourth aspect of the present invention relates to a process for the preparation of a superconducting film, the process comprising forming a Ba-Ca-Cu-O precursor film having a thickness of at least 10 microns (such as from 40 to 70 microns) and contacting the precursor film with $Tl_2O_3$ vapour.

A fifth aspect of the present invention relates to a superconducting film produced by a process of any of the first to fourth aspects of the invention.

A sixth aspect of the present invention relates to a tape or wire made from a superconducting film of the fifth aspect.

Preferred features and characteristics of one aspect of the present invention are as for another aspect *mutatis mutandis*.

The invention will now be described by way of example and without limitation with reference to the following Examples and accompanying drawings, in which:

Figure 1 is a graph of electrical resistance against temperature for a thallium oxide evaporated thick film made according to a method of the present invention; and

Figure 2 is a graph of electrical resistance against temperature for a different thallium oxide evaporated thick film made according to a method of the present invention.

Example 1:

A. The following reagents were utilized:

1. $Tl_2O_3$
2. CaO
3. $BaCO_3$
4. CuO

B. The following procedure was followed using the above reagents to create a superconductive compound:

A mixture of a two molar portion of $BaCO_3$, two molar portion of CaO, and three molar portion of CuO were ground with an agate mortar and pestle. The ground mixture was heated in air at approximately 925°C for more than 24 hours (with several intermediate grindings) to obtain a uniform black powder with a nominal composition $Ca_2Ba_2Cu_3O_7$.

After grinding the $Ca_2Ba_2Cu_3O_7$ powder was placed on a platinum substrate. It should be noted, however, that the powder could have been placed on any other suitable substrate such as copper, in powder form or in pellet form. The powder was then rolled between two rollers (AMI Center 'C", Applied Mechanics, Inc., Fayetteville, AR) at room temperature until a desired thickness of approximately 40 microns to about 70 microns was achieved. The film was then taken off the substrate to produce a free-standing precursor thick film. The resultant precursor thick film was subjected to a $Tl_2O_3$ vapor process as follows:

A small platinum boat containing a small amount of $Tl_2O_3$ approximately 0.2 to about 0.3 grams was placed in a quartz boat. The Ca-Ba-Cu-O precursor thick film was then placed above the platinum boat. The quartz boat with its contents was put into a tube furnace, which had been heated to 900°C. The quartz boat and contents were heated for about 3 minutes in flowing oxygen. This was followed by a furnace-cooling.

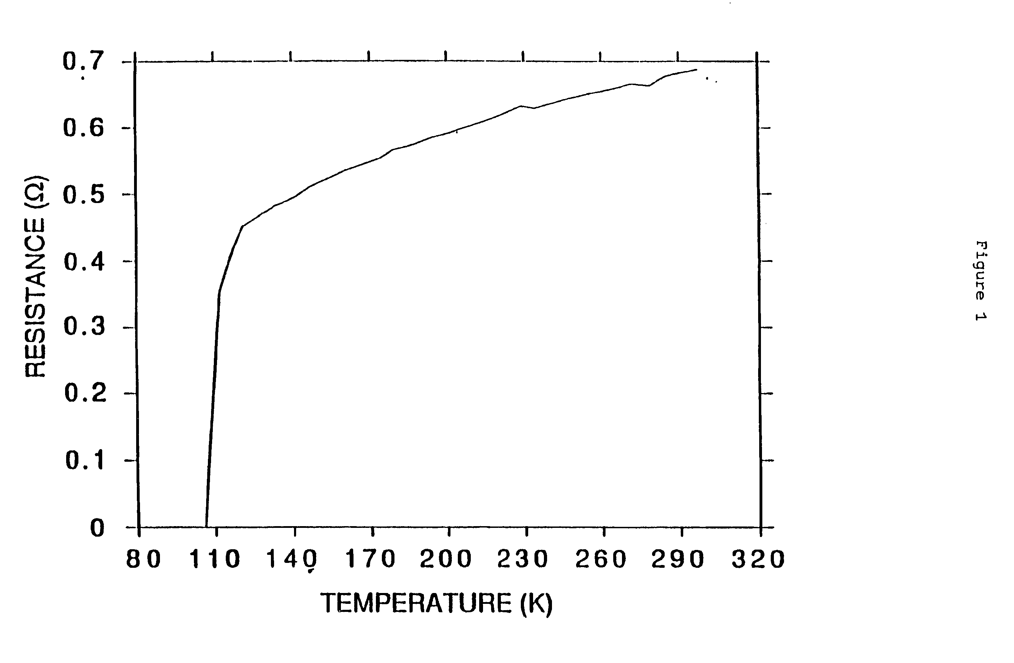

The film, produced pursuant to this example, formed a superconductive layer. Figure 1 illustrates, graphically, the resistance of a Tl-Ca-Ba-Cu-O film made pursuant to this example, as a function of temperature. The superconducting film reached zero resistance at 106K. The resultant film had the following approximate stoichiometry:

$$Tl_zCa_2Ba_2Cu_3O_{7+1.5z}$$

wherein z is greater than or equal to 0.5 and less than or equal to 2.

Example 2:

A. The following reagents were utilized:

1. $Tl_2O_3$
2. CaO
3. $BaCO_3$
4. CuO

B. The following procedure was followed using the above reagents to create a superconducting film:

A mixture of a two molar portion of $BaCO_3$, two molar portion of CaO, and three molar portion of CuO were ground with an agate mortar and pestle. The ground mixture was heated in air at approximately 925°C for more than 24 hours (with several intermediate grindings) to obtain a uniform black powder with a nominal composition of $Ca_2Ba_2Cu_3O_7$.

After grinding, the $Ca_2Ba_2Cu_3O_7$ powder was placed onto a platinum substrate. Again, it should be noted that another suitable substrate such as copper could have been utilized, in powder form or in pellet form. The powder and substrate was rolled between two rollers (AMI Center 'C", Applied Mechanics, Inc., Fayetteville, AR) at room temperature until a desired thickness of approximately 70 microns was achieved. The film was then removed from the substrate.

The precursor thick film was then subjected to a $Tl_2O_3$ thermal evaporation in a vacuum (pressure about $5 \times 10^{-6}$ Torr) with 60 amperes current flowing through the evaporation filament, (the thermal resistance evaporator used was a High Vacuum Equipment Corporation HV-4F vacuum system and C-0018 coater system). The procedure that was used was as follows:

The evaporation filament consisted of a tungsten boat. The thick film was supported on a net which was approximately 6 inches from the boat. There was a shutter between the filament and the film. The $Tl_2O_3$ was put in the tungsten boat. The bell jar of the system was lowered and evacuated to $5 \times 10^{-6}$ Torr. At this vacuum, the filament was turned on and the current increased slowly to 60 amperes wherein the thallium oxide started to evaporate. At this time, the shutter between the film and filament was removed using a mechanical handle located outside the bell jar. It took almost 30 seconds to complete the evaporation. The filament was then turned off. Air was then leaked into the system to bring the system to atmospheric pressure before the film was taken out of the bell jar.

The $Tl_2O_3$ coated film was then removed from the vacuum system and put above a platinum boat containing $Tl_2O_3$. The quartz boat with its contents was put into a tube furnace, which had been heated to 900°C. The boat and contents was heated for about 3 minutes in flowing oxygen followed by a furnace-cooling.

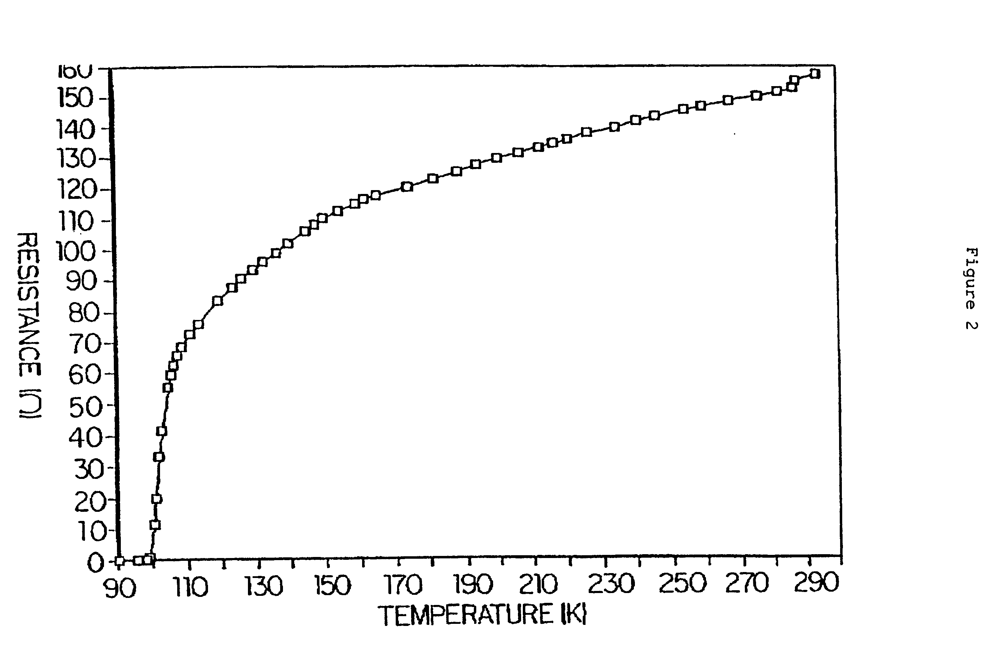

The film, produced pursuant to this example, formed a superconductive film. Figure 2 illustrates, graphically, the resistance of a Tl-Ca-Ba-Cu-O film made pursuant to this example, as a function of temperature. The film reached zero resistance at about 100 K. The superconducting film had the following approximate stoichiometry:

$$Tl_zCa_2Ba_2Cu_3O_{7+1.5z}$$

wherein z is greater than or equal to 0.5 and less than or equal to 2.

## Claims

1. A process for the preparation of a superconducting film, the process comprising evaporating $Tl_2O_3$ either in flowing oxygen at atmospheric pressure, or in a vacuum, on to a Ba-Ca-Cu-O precursor film.

2. A process as claimed in claim 1 wherein the calcium-barium-copper-oxide has the following general formula:

$$Ca_xBa_yCu_uO_v$$

wherein:

x is greater than or equal to 0.5 and less than or equal to 6;

y is greater than or equal to 0.25 and less than or equal to 2;

u is greater than or equal to 0.5 and less than or equal to 7.5; and

$x+y+u \le v \le x+y+u+2$.

3. A process as claimed in claim 1 or 2 wherein the precursor film is formed by rolling a Ca-Ba-Cu-O mixture on to a substrate.

4. A process as claimed in claim 3 wherein the Ca-Ba-Cu-O film is removed from the substrate after rolling.

5. A process as claimed in any of claims 1 to 4 additionally comprising annealing the resultant $Tl_2O_3$-coated film.

6. A process as claimed in any of claims 1 to 5 wherein the Ca-Ba-Cu-O film has a thickness of from 40 to 70 microns.

7. A process as claimed in claim 5 or 6 wherein the coated Ca-Ba-Cu-O film is annealed at 900°C in flowing $O_2$.

8. A process as claimed in any of claims 1 to 8 wherein the superconducting film is of the general formula

$Tl_2Ca_2Ba_2Cu_3O_{7+1.5z}$,

wherein z is greater than or equal to 0.5 and less than or equal to 2.

9. A superconducting film prepared by a process as claimed in any of claims 1 to 8.

10. A superconducting wire or tape formed from a film as claimed in claim 9.

**Claims for the following Contracting State:
ES**

1. A process for the preparation of a superconducting film, the process comprising evaporating $Tl_2O_3$ either in flowing oxygen at atmospheric pressure, or in a vacuum, on to a Ba-Ca-Cu-O precursor film.

2. A process as claimed in claim 1 wherein the calcium-barium-copper-oxide has the following general formula:

$$Ca_xBa_yCu_uO_v$$

wherein:

x is greater than or equal to 0.5 and less than or equal to 6;
y is greater than or equal to 0.25 and less than or equal to 2;
u is greater than or equal to 0.5 and less than or equal to 7.5; and
$x+y+u \leq v \leq x+y+u+2$.

3. A process as claimed in claim 1 or 2 wherein the precursor film is formed by rolling a Ca-Ba-Cu-O mixture on to a substrate.

4. A process as claimed in claim 3 wherein the Ca-Ba-Cu-O film is removed from the substrate after rolling.

5. A process as claimed in any of claims 1 to 4 additionally comprising annealing the resultant $Tl_2O_3$-coated film.

6. A process as claimed in any of claims 1 to 5 wherein the Ca-Ba-Cu-O film has a thickness of from 40 to 70 microns.

7. A process as claimed in claim 5 or 6 wherein the coated Ca-Ba-Cu-O film is annealed at 900°C in flowing $O_2$.

8. A process as claimed in any of claims 1 to 8 wherein the superconducting film is of the general formula

$$Tl_2Ca_2Ba_2Cu_3O_{7+1.5z}$$,

wherein z is greater than or equal to 0.5 and less than or equal to 2.

9. A process as claimed in any of claims 1 to 8 wherein the Ba-Ca-Cu-O film is made from mixing CaO, CuO and either $BaO_2$ or $BaCO_3$.

10. A process as claimed in any of claims 1 to 9 additionally comprising forming a superconducting tape or wire from the film.

Figure 1

Figure 2